(19) Europäisches Patentamt / European Patent Office / Office européen des brevets

(11) **EP 2 435 985 B1**

(12) **FASCICULE DE BREVET EUROPEEN**

(45) Date de publication et mention de la délivrance du brevet:
**20.11.2013 Bulletin 2013/47**

(21) Numéro de dépôt: **10724408.9**

(22) Date de dépôt: **28.05.2010**

(51) Int Cl.:
*G06T 7/00* (2006.01)     *G06T 7/40* (2006.01)

(86) Numéro de dépôt international:
**PCT/EP2010/057466**

(87) Numéro de publication internationale:
**WO 2010/136584 (02.12.2010 Gazette 2010/48)**

(54) **PROCEDE DE QUANTIFICATION DE L'EVOLUTION DE PATHOLOGIES IMPLIQUANT DES CHANGEMENTS DE VOLUMES DE CORPS, NOTAMMENT DE TUMEURS**

**VERFAHREN ZUR QUANTIFIZIERUNG VON PATHOLOGIEN, WELCHE VERÄNDERUNGEN IM VOLUMEN VON KÖRPERN, INSBESONDERE VON TUMOREN EINSCHLIESSEN**

**METHOD OF QUANTIFYING THE CHANGE OF PATHOLOGIES INVOLVING CHANGES IN THE VOLUME OF BODIES, ESPECIALLY OF TUMORS**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **29.05.2009 FR 0953578**

(43) Date de publication de la demande:
**04.04.2012 Bulletin 2012/14**

(73) Titulaires:
- **Institut Telecom - Telecom Paris Tech**
  **75013 Paris (FR)**
- **Université Paris Diderot - Paris 7**
  **75205 Paris Cedex 13 (FR)**
- **Centre National de la Recherche Scientifique CNRS**
  **75794 Paris Cedex 16 (FR)**

(72) Inventeurs:
- **ANGELINI, Elsa**
  **F-75013 Paris (FR)**
- **MANDONNET, Emmanuel**
  **F-75015 Paris (FR)**
- **DELON, Julie**
  **F-75011 Paris (FR)**

(74) Mandataire: **Collet, Alain et al**
**Marks & Clerk France**
**Conseils en Propriété Industrielle**
**Immeuble Visium**
**22, Avenue Aristide Briand**
**94117 Arcueil Cedex (FR)**

(56) Documents cités:
EP-A2- 0 614 153          WO-A1-00/14668
WO-A1-02/069799          WO-A1-2005/071615
WO-A2-2008/014340          US-A1- 2005 273 001

- VAIDYANATHAN M ET AL: "Comparison of supervised MRI segmentation methods for tumor volume determination during therapy" MAGNETIC RESONANCE IMAGING UK, vol. 13, no. 5, 1995, pages 719-728, XP002559150 ISSN: 0730-725X

**Description**

La présente invention concerne un procédé de quantification de l'évolution de tumeurs cérébrales. Elle s'applique notamment au suivi de l'évolution de gliomes de bas grades, mais plus généralement au suivi de tous les types de pathologies évolutives dont des méthodes d'imagerie telles que par exemple l'imagerie par résonance magnétique, plus communément désignée sous l'acronyme d'IRM, permettent le suivi.

Il est important, dans le cadre de pathologies évolutives telles que les tumeurs, et notamment les tumeurs cérébrales, d'être capable d'apprécier l'évolution de celles-ci. La détermination de la dynamique d'évolution d'une tumeur permet en effet d'affiner le pronostic individuel d'un patient, d'ajuster des moyens de thérapie en fonction de l'agressivité tumorale, ou encore d'évaluer l'efficacité de traitements.

Dans le cas particulier des pathologies cérébrales, l'imagerie par résonance magnétique ou IRM, est une modalité particulièrement appropriée pour le suivi des tumeurs ; aussi bien pour le diagnostic des tumeurs au préalable de tout traitement, que pour l'appréciation de l'efficacité du traitement. La quantification de la dynamique tumorale peut donc se faire sur la base d'une pluralité - au moins une paire - de clichés IRM. Dans la pratique, il est habituel de fonder une telle analyse sur des clichés longitudinaux provenant de deux modes d'IRM : le mode SPGR et le mode FLAIR, selon les acronymes pour les expressions anglo-saxonnes respectives de Spoiled Gradient Recall Echo et de Fluid Attenuated Inversion Recovery. Il est à noter que d'autres protocoles d'acquisition d'images par IRM existent, et que la description qui fait suite ne se rapporte à ces protocoles d'acquisition particuliers qu'à titre d'exemple.

Il est alors possible pour un médecin de pratiquer une segmentation manuelle de la tumeur sur une sélection de différents clichés, afin d'apprécier l'étendue spatiale de la tumeur à différents niveaux de coupe, à différents instants d'acquisition des clichés, et dans au moins un des deux modes d'IRM précités. Un tel travail est relativement fastidieux, et l'appréciation de la dynamique tumorale selon cette méthode est relativement dépendante de l'opérateur, c'est-à-dire que cette appréciation présente un manque de reproductibilité inter-expert ; voire, cette appréciation présente même un manque de reproductibilité intra-expert. En d'autres termes, un même opérateur peut parvenir à des conclusions différentes sur la base de clichés identiques. Cette variabilité intra-opérateur est estimée à 15%.

Il est également possible de procéder à la quantification de la croissance tumorale selon la technique en elle-même connue des plus grands diamètres. Néanmoins cette méthode présente certains inconvénients. Certains de ces inconvénients sont liés aux orientations des plans de coupe des clichés qui peuvent être différents d'un examen à l'autre. En outre, cette méthode est particulièrement inadéquate consécutivement à une intervention chirurgicale, à cause de la présence de la cavité opératoire.

Il existe des méthodes de détermination automatique de la dynamique tumorale. Notamment, il existe des méthodes de segmentation automatique de tumeurs, basées sur des algorithmes de calcul et de traitement d'image relativement complexes, mais dont il est connu qu'elles offrent une fiabilité et une robustesse relativement faibles. La variabilité des paramètres relatifs aux différents examens IRM qu'un même patient peut subir, par exemple les paramètres de fonctionnement de l'équipement d'imagerie, la position de la tête du patient lors de l'examen, les phénomènes de bruit intrinsèques de l'appareil d'imagerie et de son environnement, conduisent à des différences de contrastes entre les clichés, rendant leur comparaison directe difficile. Ainsi des changements de contrastes non-linéaires entre des jeux de clichés représentant des volumes d'une zone d'intérêt ne permettent pas d'apprécier de manière spécifique une évolution tumorale, sur la base de simples cartographies de différences entre ces clichés. Ces différences de contraste rendent donc difficile la comparaison automatique entre les clichés. Il existe certaines techniques consistant à normaliser les niveaux de gris, et apprendre des variabilités anatomiques longitudinales de bruit, permettant alors d'appliquer des corrections aux clichés afin de les rendre comparables. Néanmoins ces techniques présentent l'inconvénient d'imposer des examens IRM répétés au patient, dans le but de produire des cartographies de niveau de bruit précises. Un trop grand nombre d'examens IRM n'est bien sûr pas souhaitable, pour des raisons de coût élevé et de contraintes imposées au patient.

Une segmentation automatique est par exemple décrit dans Vaidyanatham et al.: "Comparison of supervised MRI segmentation methods for tumor volume determination during therapy", Magnetic Resonance Imaging UK, vol. 13, no. 5, 1995, pages 719-728.

Dans l'exemple des gliomes cérébraux de bas grade, il est habituel de procéder à un premier examen IRM, suivi d'un examen IRM trois mois plus tard, où une classification de la croissance du gliome est réalisée. Il convient alors, par exemple, de traiter un gliome dont la croissance après trois mois est typiquement supérieure à 2 millimètres, comme un gliome de haut grade, et un gliome dont la croissance après trois mois est inférieure à 2 millimètres, comme un gliome de bas grade. Ce type de pathologie présente typiquement des croissances des tumeurs relativement faibles, et impose donc des techniques de quantification de précision millimétrique, voire submillimétrique. Il est aussi particulièrement avantageux que ces techniques soient reproductibles, ainsi que simples et rapides à mettre en oeuvre.

Un but de la présente invention est de pallier les inconvénients précités, et de proposer une solution aux problèmes précités.

A cet effet, l'invention a pour objet un procédé de quantification de l'évolution de pathologies impliquant des changements de volume de corps représentés via une technique d'imagerie, caractérisé en ce qu'il comprend au moins :

- une première étape de normalisation de niveaux de gris par une technique mi-chemin de deux images $I_1$ et $I_2$ représentant une même scène, c'est-à-dire la même partie anatomique d'un même patient à deux instants successifs, résultant en deux images normalisées $I'_1$ et $I'_2$,
- une deuxième étape de calcul d'une carte de différences signées entre les deux images normalisées $I'_1$ et $I'_2$,
- une troisième étape comprenant au moins un test statistique se basant sur l'hypothèse d'une distribution gaussienne des niveaux de gris des tissus sains des images normalisées $I'_1$ et $I'_2$ et/ou de la carte des différences calculée à la deuxième étape.

Dans un mode de réalisation de l'invention, le procédé de quantification de l'évolution de pathologies impliquant des changements de volume de corps peut être caractérisé en ce que la première étape de normalisation détermine un histogramme cumulé de niveaux de gris mi-chemin commun aux deux images $I_1$ et $I_2$, et égal à l'inverse de la moyenne arithmétique des inverses des histogrammes cumulés de niveaux de gris des deux images normalisées $I_1$ et $I_2$, les deux images étant normalisées par application de l'histogramme cumulé mi-chemin aux deux images $I_1$ et $I_2$.

Dans un mode de réalisation de l'invention, le procédé de quantification de l'évolution de pathologies impliquant des changements de volume de corps peut être caractérisé en ce que la première étape de normalisation détermine un histogramme cumulé de niveaux de gris mi-chemin commun aux deux images $I_1$ et $I_2$, et égal à l'inverse de la moyenne géométrique des inverses des histogrammes cumulés de niveaux de gris des deux images $I_1$ et $I_2$, les deux images étant normalisées sur l'histogramme cumulé mi-chemin aux deux images $I_1$ et $I_2$.

Dans un mode de réalisation de l'invention, le procédé de quantification de l'évolution de pathologies impliquant des changements de volume de corps peut être caractérisé en ce qu'un premier test réalise la comparaison entre un rapport de vraisemblance généralisé défini par la relation :

$$GLRT = \frac{p(I'_1(x)/\mu_1,\sigma_1)\,p(I'_2(x)/\mu_2,\sigma_2)}{p(I'_1(x)/\mu_{1-2},\sigma_{1-2})\,p(I'_2(x)/\mu_{1-2},\sigma_{1-2})} ,$$

et un premier seuil de confiance $T_1$ de valeur déterminée ;
$p(I'_i(x)/\mu_i,\sigma_i)$ étant la fonction de densité de probabilité pour le niveau de gris $I'_i(x)$ d'un pixel de l'image normalisée $I'_i$, calculée avec une fonction Gaussienne de moyenne $\mu_i$ et d'écart type $\sigma_i$ de présenter le niveau de gris observé, l'indice 1-2 s'appliquant aux valeurs combinées des images normalisées $I'_1$ et $I'_2$, les statistiques pour un pixel donné étant réalisées sur une zone s'étendant autour du pixel sur un nombre déterminé de pixels.

Dans un mode de réalisation de l'invention, le procédé de quantification de l'évolution de pathologies impliquant des changements de volume de corps peut être caractérisé en ce qu'un deuxième test réalise la comparaison entre la fonction de densité de probabilité $p(I'_2(x) - I'_1(x)/\mu_2 - \mu_1, \sqrt{\sigma_1^2 + \sigma_2^2})$ et un deuxième seuil de confiance $T_2$ de valeur déterminée.

Dans un mode de réalisation de l'invention, le procédé de quantification de l'évolution de pathologies impliquant des changements de volume de corps peut être caractérisé en ce qu'un troisième test réalise la comparaison entre la valeur de probabilité $F\left(|I'_2(x) - I'_1(x)|, 0, \sqrt{\sigma_1^2 + \sigma_2^2}\right)$ et un troisième seuil de confiance $T_3$ de valeur déterminée,

la fonction $F$ désignant l'intégrale $F(t,\mu,\sigma) = 1 - \int_{-t}^{t} \frac{e^{\frac{-(s-\mu)^2}{2\sigma^2}}}{\sqrt{2\pi}\sigma} ds$ .

Dans un mode de réalisation de l'invention, le procédé de quantification de l'évolution de pathologies impliquant des changements de volume de corps peut être caractérisé en ce que la comparaison réalisée par le premier test réalisé à la troisième étape est établie par la relation suivante :

$$\ln\left(\frac{p(I'_1(x)/\mu_1,\sigma_1)\,p(I'_2(x)/\mu_2,\sigma_2)}{p(I'_1(x)/\mu_{1-2},\sigma_{1-2})\,p(I'_2(x)/\mu_{1-2},\sigma_{1-2})}\right) > \ln(T_1) .$$

Dans un mode de réalisation de l'invention, le procédé de quantification de l'évolution de pathologies impliquant des changements de volume de corps peut être caractérisé en ce que le premier seuil de confiance $T_1$ est égal à 2.

Dans un mode de réalisation de l'invention, le procédé de quantification de l'évolution de pathologies impliquant des changements de volume de corps peut être caractérisé en ce que la comparaison réalisée par le deuxième test réalisé à la troisième étape est établie par la relation suivante :

$$p(I'_2(x) - I'_1(x) / \mu_2 - \mu_1, \sqrt{\sigma_1^2 + \sigma_2^2}) < T_2,$$

Dans un mode de réalisation de l'invention, le procédé de quantification de l'évolution de pathologies impliquant des changements de volume de corps peut être caractérisé en ce que le deuxième seuil de confiance $T_2$ est égal à

$\dfrac{e^{-\alpha}}{\sqrt{2\pi\sigma_n^2}}$, $\alpha$ étant un nombre réel positif non nul paramétrable, et $\sigma_n$ représentant l'écart type du bruit dans la carte des différences.

Dans un mode de réalisation de l'invention, le procédé de quantification de l'évolution de pathologies impliquant des changements de volume de corps peut être caractérisé en ce que la comparaison réalisée par le troisième test réalisé à la troisième étape est établie par la relation suivante :

$$p(I'_2(x) - I'_1(x) / 0, \sqrt{\sigma_1^2 + \sigma_2^2}) < T_3,$$

le troisième seuil de confiance $T_3$ étant un nombre réel positif non nul très petit devant 1.

Dans un mode de réalisation de l'invention, le procédé de quantification de l'évolution de pathologies impliquant des changements de volume de corps peut être caractérisé en ce que les tests réalisés à la troisième étape sont réalisés pour tous les pixels constituant les images normalisées $I'_1$ et $I'_2$ et/ou la carte des différences calculée à la deuxième étape.

Dans un mode de réalisation de l'invention, le procédé de quantification de l'évolution de pathologies impliquant des changements de volume de corps peut être caractérisé en ce que les tests réalisés à la troisième étape sont réalisés sur la base de moyennes locales se fondant sur des pluralités de pixels des images normalisées $I'_1$ et $I'_2$ et/ou de la carte des différences calculée à la deuxième étape formant une pluralité de zones couvrant les images normalisées $I'_1$ et $I'_2$ et/ou la carte des différences.

Dans un mode de réalisation de l'invention, le procédé de quantification de l'évolution de pathologies impliquant des changements de volume de corps peut être caractérisé en ce que le premier test et/ou le deuxième test et/ou le troisième test sont réalisés à la troisième étape, les résultats de ces tests étant combinés lors d'une quatrième étape.

Dans un mode de réalisation de l'invention, le procédé de quantification de l'évolution de pathologies impliquant des changements de volume de corps peut être caractérisé en ce que ladite pathologie est une tumeur cérébrale.

La présente invention a également pour objet un dispositif de programme d'ordinateur, caractérisé en ce qu'il met en oeuvre un procédé de quantification de l'évolution de pathologies impliquant des changements de volume de corps selon l'un des modes de réalisation décrits ci-dessus.

D'autres caractéristiques et avantages de l'invention apparaîtront à la lecture de la description, donnée à titre d'exemple, faite en regard des dessins annexés qui représentent :

- la figure 1, un ordinogramme illustrant une séquence d'étapes d'un procédé de quantification de l'évolution de tumeurs selon un exemple de mode de réalisation de la présente invention ;
- la figure 2, un ordinogramme illustrant la première étape de normalisation de deux images, selon un exemple de mode de réalisation de la présente invention ;
- la figure 3, des exemples d'images IRM selon deux modes d'imagerie, et de cartes des différences réalisées selon différentes techniques ;
- La figure 4, des exemples d'images IRM représentatives d'une étape de caractérisation de croissance tumorale du procédé selon la présente invention.

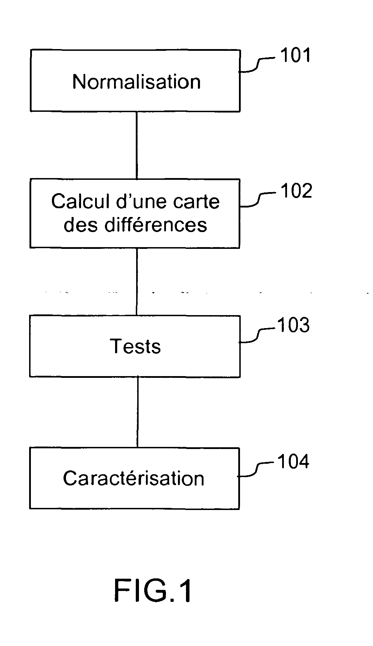

La figure 1 présente un ordinogramme illustrant une séquence d'étapes d'un procédé de quantification de l'évolution de tumeurs selon un mode de réalisation de la présente invention.

Pour la suite, dans un souci de clarté, on considérera deux images d'un volume d'intérêt comprenant une tumeur, prises par IRM selon un mode particulier de fonctionnement, à des instants $t_1$ et $t_2$, l'instant $t_1$ étant antérieur à l'instant $t_2$. Il est bien entendu que le procédé selon l'invention peut s'appliquer à une pluralité de jeux d'au moins deux images réalisées selon différents modes de fonctionnement IRM, prises à au moins deux instants. Plus généralement, le procédé selon l'invention peut s'appliquer à des techniques d'imagerie autres que l'IRM.

Il est également bien entendu qu'une étape préalable, non représentée sur la figure, et indispensable pour tous les traitements ultérieurs, consiste à recaler les deux images originales prises aux instants $t_1$ et $t_2$, pour obtenir deux images $I_1$ et $I_2$, afin que des calculs communs pixel à pixel soient possibles dans des conditions optimales. Des techniques de recalage sont en elles-mêmes connues de l'état de la technique, et ne sont donc pas développées dans la présente description.

En référence à la figure 1, une première étape 101 a pour but de normaliser les images $I_1$ et $I_2$. Une deuxième étape 102 a pour but de constituer une carte des différences entres les deux images normalisées à l'étape 101. Une troisième étape 103 a pour but de réaliser des tests statistiques sur la base des images normalisées et/ou de la carte des différences constituée à l'étape 102. Avantageusement une quatrième étape 104 a pour but d'exploiter les résultats des tests réalisés à la troisième étape 103 pour caractériser l'évolution tumorale.

La première étape 101 de normalisation permet de s'affranchir des variations de contraste entre les deux images $I_1$ et $I_2$.

Il est en effet nécessaire, au préalable d'une comparaison entre les images $I_1$ et $I_2$, de modifier ces deux images afin de les porter à une radiométrie commune. La radiométrie d'une image s'entend comme la dynamique des niveaux de gris de cette image.

Une radiométrie commune aux deux images permet de focaliser leur comparaison sur les aspects géométriques de celles-ci, représentatives de l'état réel de la zone d'intérêt de laquelle ces images ont été réalisées. Il est cependant nécessaire qu'une telle modification ne modifie pas les caractéristiques géométriques des images $I_1$ et $I_2$,.

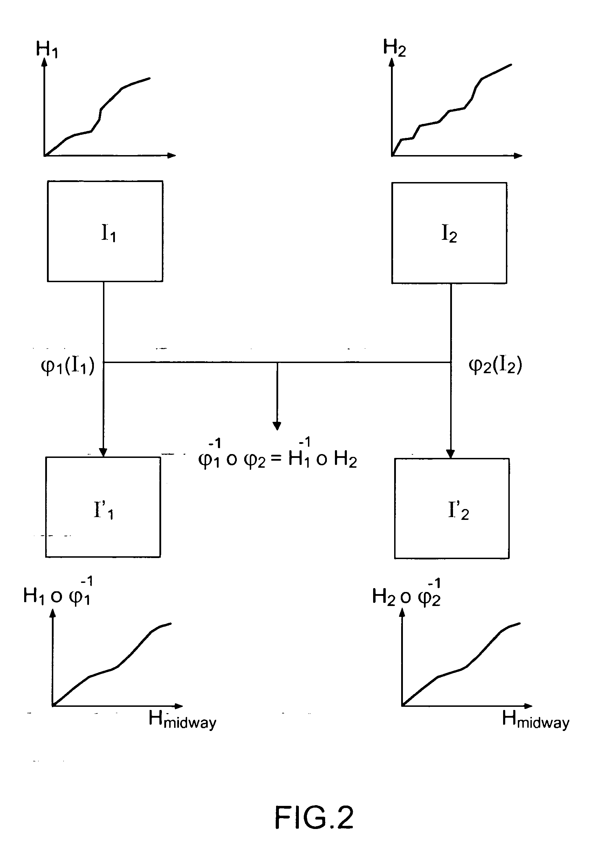

Pour satisfaire ces besoins, la présente invention propose de procéder, à la première étape 101 du procédé dont elle fait l'objet, à une  normalisation selon la méthode dite d'égalisation "mi-chemin", qu'il est encore possible de désigner par le terme anglo-saxon équivalent "midway", décrite en détails ci-après, en référence à la figure 2. Pour une description exhaustive de la méthode d'égalisation mi-chemin, il est également possible de se référer à l'article de J. Delon, Midway Image Equalization, paru dans le Journal of Mathematical Imaging and Vision, 2004. 21(2) : p. 119-134.

Les modifications des images $I_1$ et $I_2$ réalisées lors de la première étape 101 résultent en deux images normalisées $I'_1$ et $I'_2$.

La deuxième étape 102 permet d'établir une carte des différences entre les images normalisées $I'_1$ et $I'_2$.

Une carte des différences entre les deux images normalisées $I'_1$ et $I'_2$ est une image dont la définition est la même que celle des images normalisées $I'_1$ et $I'_2$, mais où le niveau de gris de chaque pixel de cette image résulte de la différence entre les niveaux de gris correspondants des deux images normalisées $I'_1$ et $I'_2$. Il est à noter qu'il est possible de réaliser à l'étape 102 un affichage de la carte des différences ; celui-ci impose un calcul de la valeur absolue des différences entre les niveaux de gris ; en revanche, pour tous les calculs explicités ci-dessous, il faudra considérer la différence signée entre les niveaux de gris des deux images normalisées $I'_1$ et $I'_2$.

Il est alors possible de caractériser simplement l'évolution tumorale, par exemple par le comptage des pixels de la carte des différences dont la valeur de niveau de gris est supérieure ou inférieure à une valeur de seuil prédéterminée. Néanmoins, la sélectivité d'une telle méthode simple de seuillage est relativement faible. En effet, même si une carte des différences met clairement en évidence la croissance tumorale, correspondant à de grandes différences de niveaux de gris entre les images normalisées $I'_1$ et $I'_2$, la valeur de ces différences est en revanche totalement imprédictible. Ceci est dû au fait que les tissus tumoraux sont de nature relativement hétérogène, et leur nature peut varier de manière importante entre deux examens IRM. De plus, certaines structures cérébrales telles que les ventricules, contenant du liquide céphalo-rachidien, et les tissus avoisinants, tels que les graisses ou bien les os du crâne, peuvent également présenter des valeurs de différences relativement hétérogènes.

Ainsi la troisième étape 103 est proposée ; cette étape permet d'affiner la caractérisation de l'évolution tumorale.

La troisième étape comprend au moins un test statistique.

Le test réalisé à la troisième étape 103 peut par exemple être un premier test statistique fondé sur une hypothèse communément acceptée. Selon cette hypothèse, pour des tissus cérébraux dits normaux, tels que les tissus constituant la matière blanche, la matière grise et le liquide céphalo-rachidien, les niveaux de gris des pixels suivent individuellement des distributions gaussiennes. Ainsi, pour chaque pixel d'une image - et par extension, pour chaque voxel de la zone volumique d'intérêt - les valeurs de niveaux de gris des pixels des deux images normalisées $I'_1$ et $I'_2$ peuvent présenter deux configurations.

Dans une première configuration, ces valeurs de niveaux de gris peuvent correspondre à une même distribution gaussienne, auquel cas aucun changement de type de tissu ne s'est produit entre les instants $t_1$ et $t_2$ de réalisation des images dont $I_1$ et $I_2$ sont issues, et grâce à la normalisation par égalisation mi-chemin réalisée à la première étape 101, ces valeurs de niveau de gris entre les deux images normalisées $I'_1$ et $I'_2$ peuvent être directement comparées.

Dans une seconde configuration, ces valeurs de niveaux de gris peuvent correspondre à deux distributions différentes, du fait d'un changement de type de tissu produit entre les instants $t_1$ et $t_2$ de réalisation des clichés originaux.

Ainsi la présente invention propose avantageusement de réaliser à la troisième étape 103 un premier test statistique de type test du rapport de vraisemblance généralisé, ou GLRT selon l'acronyme anglo-saxon de Generalized Likelihood Ratio Test, afin de caractériser les différences de niveaux de gris selon l'une ou l'autre des configurations précitées. Le rapport de vraisemblance GLRT pour un pixel donné peut être calculé selon la relation suivante :

$$GLRT = \frac{p(I'_1(x)/\mu_1,\sigma_1)p(I'_2(x)/\mu_2,\sigma_2)}{p(I'_1(x)/\mu_{1-2},\sigma_{1-2})p(I'_2(x)/\mu_{1-2},\sigma_{1-2})} \qquad (1) \; ;$$

où $I'_1(x)$ et $I'_2(x)$ sont respectivement les valeurs normalisées de niveaux de gris des pixels correspondants des images normalisées $I'_1$ et $I'_2$, $(\mu_i,\sigma_i)_{i=1,2}$ sont la moyenne et l'écart type de la distribution du pixel correspondant des images normalisées $I'_i$, et $(\mu_{1-2},\sigma_{1-2})$ sont la moyenne et l'écart type de la distribution des pixels issus des deux images normalisées $I'_1$ et $I'_2$, désignés pour la suite pixels combinés des images normalisées $I'_1$ et $I'_2$.

La fonction de densité de probabilité, ou PDF selon l'acronyme anglo-saxon pour Probability Density Function, notée $p(x/\mu_i,\sigma_i)$ est modélisée comme une PDF Gaussienne $N(\mu,\sigma)$ entièrement caractérisée par sa moyenne $\mu$ et son écart type $\sigma$. D'une manière générale, et applicable à toutes les relations dans lesquelles ce terme intervient, celui-ci est donné par la relation suivante :

$$p(x/\mu,\sigma) = \frac{1}{\sqrt{2\pi}\sigma} e^{\frac{(x-\mu)^2}{2\sigma^2}} \qquad (2).$$

Il est à noter que toutes les statistiques $(\mu,\sigma)$ pour les PDF sont estimées localement, en chaque pixel dans des zones de nxn pixels. Ainsi, lorsqu'il est fait référence à un test, il faut comprendre qu'une pluralité de tests, visant à couvrir l'intégralité des pixels constituant les images, sont nécessaires à la mise en oeuvre de l'invention.

On considère que ce rapport de vraisemblance GLRT est très supérieur à 1 dans les cas correspondant à la deuxième configuration précitée, c'est à dire où l'hypothèse de distributions distinctes est la plus probable ou en d'autres termes, où les niveaux de gris des pixels des images normalisées $I'_1$ et $I'_2$ proviennent de distributions différentes.

Il est alors possible d'apprécier les changements au niveau d'un pixel par comparaison du rapport de vraisemblance avec un premier seuil de confiance $T_1$ de valeur déterminée.

Avantageusement, il peut être considéré que le changement au niveau d'un pixel est significatif si la valeur de $+\ln(GLRT)$ est supérieure à $\ln(2)$, soit :

$$\ln\left(\frac{p(I'_1(x)/\mu_1,\sigma_1)p(I'_2(x)/\mu_2,\sigma_2)}{p(I'_1(x)/\mu_{1-2},\sigma_{1-2})p(I'_2(x)/\mu_{1-2},\sigma_{1-2})}\right) > \ln(2) \qquad (3).$$

Cette valeur de seuil prend en compte le fait que le produit de PDF du numérateur de la relation (1) précitée, implique deux écarts-types, alors que seulement un écart-type est impliqué dans le dénominateur de la relation (3).

Il est également possible de réaliser à la troisième étape 103 un deuxième type de test statistique basé sur l'hypothèse d'une distribution gaussienne de la carte des différences. Le principe de ce deuxième test statistique est d'évaluer la probabilité qu'une valeur de niveau de gris d'un pixel de la carte des différences soit issue d'une distribution gaussienne, sur la base des statistiques individuelles locales $(\mu_i,\sigma_i)_{i=1,2}$ propres aux images normalisées $I'_1$ et $I'_2$.

Ce deuxième test statistique peut se fonder sur l'hypothèse que si des pixels représentant des tissus homogènes présentent individuellement des distributions gaussiennes, alors les pixels correspondants de la carte des différences $I'_2$-$I'_1$ présentent eux aussi des distributions gaussiennes de moyenne $\mu_2 - \mu_1$ et d'écart type $\sqrt{\sigma_1^2 + \sigma_2^2}$. Il est alors possible de déduire les statistiques pour un modèle gaussien des différences sur la base des images $I'_1$ et $I'_2$, et générer une carte représentative de la probabilité pour que les valeurs actuelles de différences suivent cette distribution. Cette probabilité a donc une valeur d'autant plus élevée que la valeur de différence est bien modélisée par la distribution gaussienne proposée par le modèle, et une valeur d'autant plus faible que la valeur de différence est mal interprétée par le modèle gaussien, ou en d'autres termes, que la modélisation de la différence par une différence de distributions gaussiennes est inappropriée.

Selon un exemple de mode de réalisation de l'invention, il est possible de considérer un changement au niveau d'un pixel comme significatif, si cette probabilité est inférieure à un deuxième seuil de confiance $T_2$.

Afin de discriminer les valeurs significatives de différences, il est nécessaire de prendre en compte la variabilité des valeurs de niveaux de gris des pixels dans les zones homogènes, cette variabilité étant due au bruit, et d'établir le deuxième seuil de confiance $T_2$. Il est par exemple possible de définir ce deuxième seuil de confiance $T_2$ de manière définitive, ou bien en proposant à un opérateur des moyens pour l'ajuster. Ce deuxième seuil de confiance $T_2$ peut être utilisé comme un paramètre de contrôle du type d'estimation de la croissance tumorale qui est envisagé, par exemple en fonction du dossier du patient. Ainsi, une estimation plutôt conservative ou optimiste de la croissance tumorale peut se baser sur une valeur faible du deuxième seuil de confiance $T_2$, alors qu'une estimation plutôt pessimiste peut se fonder sur une valeur élevée de ce seuil.

Dans un exemple de mode de réalisation de l'invention, il est possible de procéder à une estimation de la variance du bruit $\sigma_{n1}^2$ et $\sigma_{n2}^2$ dans les images normalisées I'$_1$ et I'$_2$, en estimant la variance dans une zone du fond d'image, c'est-à-dire une zone ne correspondant pas à une structure anatomique mais à de l'air. Il est également possible de considérer une pluralité de zones du fond d'image, et de calculer alors une valeur moyenne de ces variances. Il est ensuite possible de définir la variance $\sigma_n^2$ du bruit dans la carte des différences, comme la somme des variances $\sigma_{n1}^2$ et $\sigma_{n2}^2$.

Il peut être alors prévu de définir le deuxième seuil de confiance $T_2$ par une valeur déterminée selon la relation :

$$T_2 = \frac{e^{-\alpha}}{\sqrt{2\pi\sigma_n^2}} \qquad (4) \; ;$$

où $\alpha$ est un coefficient réel ajustable.

Ainsi à l'issue de ce test statistique, il pourra être considéré que les changements au niveau d'un pixel sont significatifs si la fonction PDF associée est inférieure au deuxième seuil de confiance $T_2$, soit :

$$p(I'_2(x) - I'_1(x) / \mu_2 - \mu_1, \sqrt{\sigma_1^2 + \sigma_2^2}) < \frac{e^{-\alpha}}{\sqrt{2\pi\sigma_n^2}} \qquad (5).$$

Le deuxième seuil de confiance défini par la relation (4) ne reflète pas un modèle de bruit blanc gaussien pour le bruit IRM, mais plutôt un modèle des valeurs de différences de type distribution gaussienne avec une valeur moyenne nulle et une valeur estimée de variance de bruit.

Il est par exemple possible de choisir la valeur appropriée du deuxième seuil de confiance $T_2$ en se basant sur les données individuelles du patient, et en restreignant la croissance tumorale à un pourcentage donné de la taille de la tumeur initiale. Par exemple, il est possible de commencer avec une valeur nulle de $\alpha$, puis d'augmenter cette valeur par incréments de 0,01, jusqu'à obtenir le plus petit deuxième seuil de confiance $T_2$ pour lequel le deuxième test statistique réalisée à la troisième étape 103 conduit à moins de 75% de croissance tumorale par exemple, cette valeur étant appropriée dans le cas particulier d'une croissance tumorale lente liée à un gliome cérébral de bas-grade.

Dans un mode de réalisation de l'invention, il peut être réalisé à la troisième étape 103, un troisième type de test statistique portant sur la carte des différences, se fondant sur l'hypothèse que la moyenne des différences pour un point donné, ou bien pour une valeur moyenne dans une zone donnée autour de ce point, est nulle. Dans ce troisième type de test, c'est la probabilité $F(|I'_2(x) - I'_1(x)|, 0, \sqrt{\sigma_1^2 + \sigma_2^2})$ qui est comparée à un troisième seuil de confiance de valeur déterminée $T_3$, avec une sélection des différences significatives quand la probabilité est plus petite qu'un seuil déterminé: Le troisième seuil de confiance $T_3$ est un réel positif non nul très petit devant 1.

Pour tous les tests décrits ci-dessus, la croissance tumorale peut par exemple être déterminée sur la base d'une tumeur identifiée initialement à l'instant $t_1$. L'identification de la tumeur initiale peut être réalisée de manière manuelle par le praticien, ou bien selon une méthode connue de segmentation automatique, par exemple.

Il est également à remarquer que les tests précités peuvent être réalisés isolément, ou bien combinés entre eux, de manière à offrir une meilleure spécificité. Il est par exemple possible d'utiliser seulement le premier test statistique de type GLRT, ou bien seulement le deuxième test statistique reposant sur une hypothèse de distribution gaussienne de la carte des différences, ou bien seulement le troisième test statistique reposant sur une hypothèse d'égalité des moyennes de différences, ou bien encore une combinaison du premier type de test précité et du deuxième, une combinaison du premier type de test et du troisième, une combinaison du deuxième type de test et du troisième, ou enfin une combinaison des trois types de tests précités.

D'autres tests statistiques spécifiques peuvent être envisagés : il est à retenir que tous les tests se basent sur une hypothèse de distributions Gaussiennes aux temps $t_1$ et $t_2$ pour les tissus cérébraux sains, c'est-à-dire autres que les tissus constituant la tumeur. Certains tests supposent en plus que les distributions sont les mêmes (soit par vraisemblance comme dans le premier type de test précité, soit par test d'égalité des moyennes, comme dans le troisième type de test décrit ci-dessus).

Il est également à noter que les différences signées précédemment évoquées peuvent aussi bien correspondre à la différence $I'_2 - I'_1$ ou $I'_1$ et $I'_2$ entre les images normalisées, avec les moyennes respectives $\mu_2-\mu_1$ ou $\mu_1-\mu_2$ ou 0.

En outre, tous les tests décrits ci-dessus se font sur les valeurs de gris ou de différences originales, ou sur des valeurs moyennes locales. Dans ce dernier cas, il faut alors prendre en compte le fait que l'écart type local des valeurs diminue comme l'inverse de la racine carrée du nombre de points pris en considération.

La quatrième étape 104 consiste avantageusement à combiner les résultats des tests statistiques réalisés à la troisième étape 103 afin de caractériser la croissance tumorale. Cette combinaison permet de conférer au procédé selon l'invention une sensibilité et une sélectivité optimales. Chacun des types de tests décrits ci-dessus résulte par exemple en une image contenant des valeurs booléennes. Il est ainsi possible de combiner plusieurs types de tests en procédant à la multiplication bit à bit, pixel par pixel, de ces images binaires résultant des différents types de tests.

La figure 2 présente un ordinogramme illustrant la première étape de normalisation de deux images, selon un exemple de mode de réalisation de la présente invention.

Il est rappelé ici que le principe de la normalisation par égalisation mi-chemin, réalisé à la première étape 101 du procédé selon la présente invention, est d'attribuer à une paire d'images $I_1$ et $I_2$ une distribution commune de niveaux de gris. Cette distribution est définie comme un histogramme correspondant à un "mi-chemin" raisonnable, c'est-à-dire comme l'inverse de la moyenne des histogrammes cumulés inverses de niveaux de gris des images $I_1$ et $I_2$.

Ainsi qu'il est illustré sur la figure 2, l'image $I_1$ est soumise à une modification via une première fonction de changement de contraste $\Phi_1$, pour obtenir l'image normalisée $I'_1$. De la même manière, l'image $I_2$ est soumise à une modification via une seconde fonction de changement de contraste $\Phi_2$, de manière à obtenir l'image normalisée $I'_2$. L'histogramme cumulé de niveaux de gris de l'image $I_1$ est noté $H_1$, et l'histogramme cumulé de niveaux de gris de l'image $I_2$ est noté $H_2$. Les histogrammes cumulés $H_1$ et $H_2$ sont deux fonctions croissantes. Selon le principe de normalisation par égalisation mi-chemin, les histogrammes cumulés de niveaux de gris des images normalisées $I'_1$ et $I'_2$ sont quasiment identiques. Cet histogramme cumulé est noté $H_{midway}$.

Ainsi qu'il est décrit dans l'article de J. Delon précité, des fonctions de changement de contraste $\Phi_1$ et $\Phi_2$ telles que $\Phi_1(I_1)$ et $\Phi_2(I_2)$ présentent le même histogramme cumulé $H_{midway}$ imposent et supposent que la relation suivante soit vérifiée :

$$\Phi_1^{-1} \circ \Phi_2 = H_1^{-1} \circ H_2 \qquad (6).$$

Selon un exemple de mode de réalisation de la présente invention, l'histogramme cumulé mi-chemin $H_{midway}$ peut alors être déterminé par la relation suivante :

$$H_{midway} = \left( \frac{H_1^{-1} + H_2^{-1}}{2} \right)^{-1} \qquad (7).$$

Les images normalisées $I'_1$ et $I'_2$, qui sont les images $I_1$ et $I_2$ que l'on normalise sur l'histogramme cumulé mi-chemin $H_{midway}$, sont alors données par les relations suivantes :

$$I'_1 = \frac{I_1 + H_2^{-1} \circ H_1(I_1)}{2} \qquad (8),$$

et

$$I'_2 = \frac{I_2 + H_1^{-1} \circ H_2(I_2)}{2} \qquad (9).$$

Avantageusement, il peut être envisagé de définir l'histogramme mi-chemin $H_{midway}$ non pas par une moyenne arithmétique des inverses des histogrammes cumulés $H_1$ et $H_2$, mais plutôt par une moyenne géométrique de ces derniers. Ce mode de réalisation peut s'avérer approprié dans une application à des images IRM, car les non-homogénéités du champ généré par des équipements IRM peuvent typiquement être modélisées comme des champs multiplicatifs. En d'autres termes l'intensité d'un pixel d'une image I donné est en fait formalisée par I(x).g(x), g étant une fonction de non-homogénéité.

De la sorte, dans ce mode de réalisation de l'invention, l'histogramme cumulé mi-chemin $H_{midway}$ peut être déterminé par la relation suivante :

$$H_{midway} = \left(\sqrt{H_1^{-1} H_2^{-1}}\right)^{-1} \qquad (10).$$

Les images normalisées $I'_1$ et $I'_2$ peuvent alors être données par les relations suivantes :

$$I'_1 = \sqrt{I_1.H_2^{-1} \circ H_1(I_1)} \qquad (11),$$

et

$$I'_2 = \sqrt{I_2.H_1^{-1} \circ H_2(I_2)} \qquad (12).$$

Il est admis que la fonction g(x) est uniforme spatialement, et qu'elle varie peu localement. On peut donc faire l'hypothèse que la fonction g(x) est assimilable à une constante, sur des zones spatiales restreintes. Il peut être ainsi avantageusement envisagé, d'appliquer la normalisation par égalisation mi-chemin par petites zones d'images.

Il est à noter que tous les calculs présentés ci-dessus s'appliquent dans le cas où deux clichés sont disponibles, correspondant à des instants d'examen $t_1$ et $t_2$. Dans le cas où les clichés sont disponibles à une pluralité N d'instants $t_N$, il est bien sûr possible de transposer les relations (7) à (9), et (10) à (12), en utilisant des moyennes respectivement arithmétiques et géométriques, pour N histogrammes cumulés inverses.

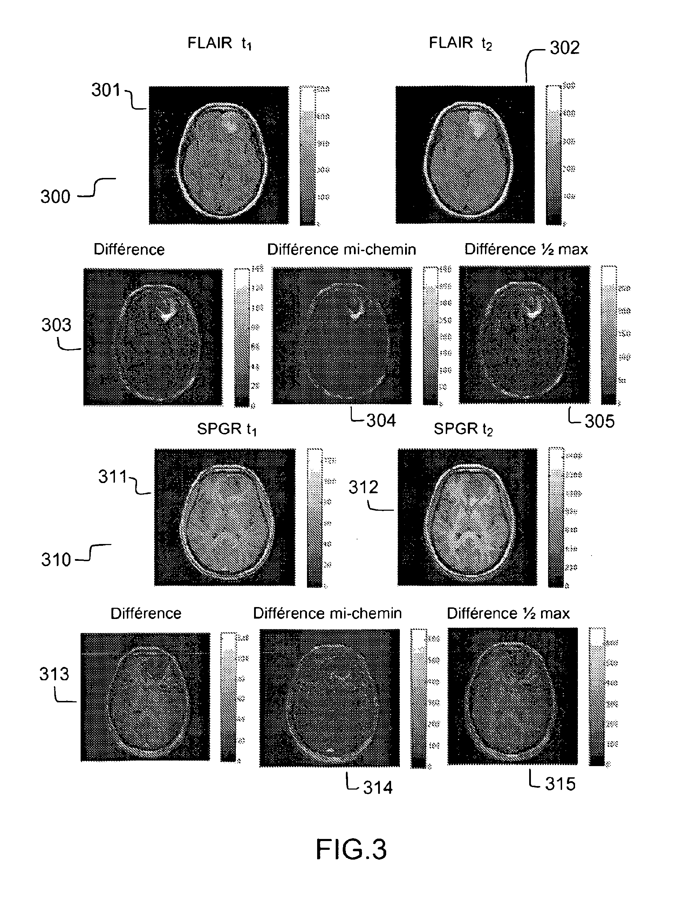

La figure 3 présente des exemples d'images IRM d'un cerveau humain à un niveau de coupe donné, selon deux protocoles d'acquisition, et de cartes des différences réalisées selon différentes techniques. Cette figure aide à la bonne compréhension de la première étape (101) du procédé selon la présente invention, sur la base d'exemples issus de cas réels.

Une première série d'images 300 comprend une première image FLAIR 301 réalisée au temps $t_1$ selon le mode IRM FLAIR, et une seconde image FLAIR 302 réalisée au temps $t_2$. Les deux images FLAIR 301 et 302 sont recalées.

Une première carte des différences FLAIR 303 est réalisée simplement sur la base d'une différence entre les deux premières images FLAIR 301 et 302.

Une seconde carte des différences FLAIR 304 est réalisée sur la base d'une différence entre les deux premières images FLAIR 301 et 302, normalisées par égalisation mi-chemin selon le procédé de la présente invention.

Une troisième carte des différences FLAIR 305 est réalisée sur la base d'une différence entre les deux premières images FLAIR 301 et 302, normalisées par une technique de normalisation de type "demi-maximum" connue de l'état de la technique.

Une seconde série d'images 310 comprend une première image SPGR 311 réalisée au temps $t_1$ selon le mode IRM SPGR, et une seconde image SPGR 312 réalisée au temps $t_2$. Les deux images SPGR 311 et 312 sont recalées.

Une première carte des différences SPGR 313 est réalisée simplement sur la base d'une différence entre les deux premières images SPGR 311 et 312.

Une seconde carte des différences SPGR 314 est réalisée sur la base d'une différence entre les deux premières images SPGR 311 et 312, normalisées par égalisation mi-chemin selon le procédé de la présente invention.

Une troisième carte des différences SPGR 315 est réalisée sur la base d'une différence entre les deux premières images SPGR 311 et 312, normalisées par une technique de normalisation de type "demi-maximum" connue de l'état de la technique.

Les images présentées à titre d'exemples dans la figure 3 soulignent la supériorité de la technique de normalisation mi-chemin employée dans le procédé selon la présente invention, par rapport à des techniques connues de l'état de la technique, pour l'élaboration de cartes de différences permettant de mettre en valeur une croissance tumorale.

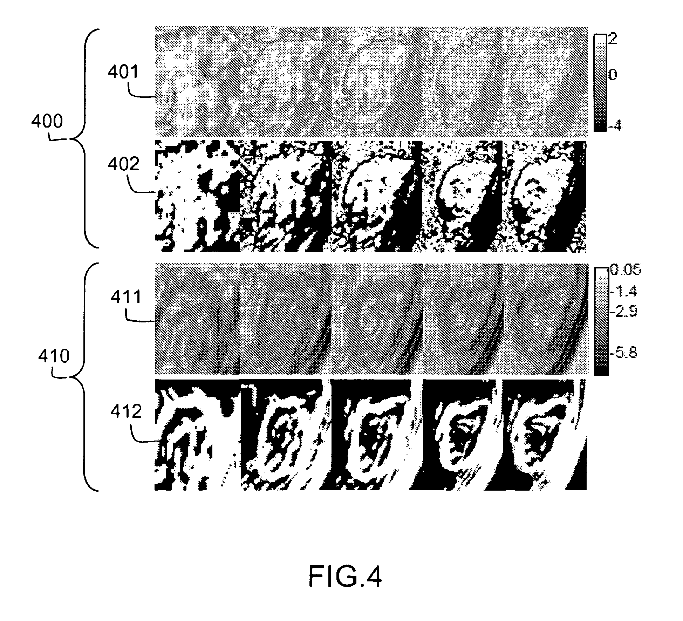

La figure 4 présente des exemples d'images IRM au niveau d'une zone tumorale d'un cerveau humain, représentatives de la troisième étape 103 du procédé selon la présente invention.

Une première série d'images 400 est représentative du premier type de test tel que décrit ci-dessus, réalisé à la troisième étape 103. Une seconde série d'images 410 est représentative du deuxième type de test tel que décrit ci-dessus, réalisé à la troisième étape 103.

Dans la première série d'images 400, une première série d'images du premier test 401 représente des cartes des rapports de vraisemblance GLRT calculés au premier type de test de la troisième étape 103 du procédé de l'invention, selon la relation (1). Une deuxième série d'images du premier test après comparaison 402 représente les images de pixels booléens obtenues après comparaison des GLRT à un seuil de valeur prédéterminée, telle que formalisée par la relation (3). Ces pixels booléens représentent les différences significatives selon les critères du premier type de test réalisé à l'étape 103.

Dans la deuxième série d'images 410, une première série d'images 411 du deuxième type de test représente des cartes des fonctions de densité de probabilités des différences gaussiennes calculés au deuxième type de test réalisé à la troisième étape 103. Une deuxième série d'images du deuxième type de test après comparaison 412 représente les images de pixels booléens obtenues après comparaison des fonctions de densité de probabilités précitées à un seuil de valeur prédéterminée, telle que formalisée par la relation (5). Ces pixels booléens représentent les différences significatives selon les critères du deuxième type de test.

Les photographies présentées à titre d'exemples dans la figure 4 soulignent les différences caractéristiques des résultats obtenus via les deux types de tests réalisés à la troisième étape 103 du procédé selon la présente invention. Notamment, il peut être observé sur cette figure que des différences significatives communes sont détectées sur la totalité de la zone de tumeur de type hétérogène, et que la sélectivité des tests est différente, au niveau des zones de l'os crânien.

Cet exemple souligne en outre l'avantage procuré par la quatrième étape 104 du procédé selon l'invention, permettant de combiner les deux types de tests afin de procurer une sensibilité et une sélectivité optimales.

Il est enfin à noter que tous les exemples présentés dans la présente description s'appliquent à des tumeurs cérébrales. Il est cependant possible d'appliquer le procédé selon l'invention, à la quantification de l'évolution de tout type de pathologie évolutive dont des méthodes d'imagerie permettent le suivi. Notamment, le procédé selon l'invention peut s'appliquer à la quantification de l'évolution de différents types de tumeurs, ou bien de la croissance osseuse, ou bien encore de la croissance de scléroses.

Le procédé de l'invention peut être mis en oeuvre dans tout dispositif ou dispositif de programme d'ordinateur, destiné à l'analyse d'images et/ou à l'aide au diagnostic.

L'exploitation du procédé selon l'un des modes de réalisation présentés procure notamment la possibilité d'organiser par imagerie un dépistage de masse de toute pathologie, en particulier cérébrale, en appliquant l'algorithme à la détection d'une différence entre une IRM de référence et l'IRM du patient testé. En cas d'anomalie, après relecture par un radiologue, la présente invention permet également le suivi longitudinal de celle-ci, afin d'adapter la stratégie thérapeutique en cas d'évolutivité.

**Revendications**

**1.** Procédé de quantification de l'évolution de pathologies impliquant des changements de volume de corps représentés via une technique d'imagerie, **caractérisé en ce qu'**il comprend au moins :

- une première étape (101) de normalisation de niveaux de gris par une technique mi-chemin de deux images $I_1$ et $I_2$ représentant une même scène, résultant en deux images normalisées $I'_1$ et $I'_2$,
- une deuxième étape (102) de calcul d'une carte de différences signées entre les deux images normalisées $I'_1$ et $I'_2$,
- une troisième étape (103) comprenant au moins un test statistique se basant sur l'hypothèse d'une distribution gaussienne des niveaux de gris des tissus sains des images normalisées $I'_1$ et $I'_2$ et/ou de la carte des différences calculée à la deuxième étape (102).

2. Procédé de quantification de l'évolution de pathologies impliquant des changements de volume de corps selon la revendication 1, **caractérisé en ce que** la première étape (101) de normalisation détermine un histogramme cumulé de niveaux de gris mi-chemin commun aux deux images $I_1$ et $I_2$, et égal à l'inverse de la moyenne arithmétique des inverses des histogrammes cumulés de niveaux de gris des deux images normalisées $I_1$ et $I_2$, les deux images étant normalisées par application de l'histogramme cumulé mi-chemin aux deux images $I_1$ et $I_2$.

3. Procédé de quantification de l'évolution de pathologies impliquant des changements de volume de corps selon la revendication 1, **caractérisé en ce que** la première étape (101) de normalisation détermine un histogramme cumulé de niveaux de gris mi-chemin commun aux deux images $I_1$ et $I_2$, et égal à l'inverse de la moyenne géométrique des inverses des histogrammes cumulés de niveaux de gris des deux images $I_1$ et $I_2$, les deux images étant normalisées sur l'histogramme cumulé mi-chemin aux deux images $I_1$ et $I_2$.

4. Procédé de quantification de l'évolution de pathologies impliquant des changements de volume de corps selon l'une quelconque des revendications précédentes, **caractérisé en ce qu'**un premier test réalise la comparaison entre un rapport de vraisemblance généralisé défini par la relation :

$$GLRT = \frac{p(I'_1(x)/\mu_1,\sigma_1)\,p(I'_2(x)/\mu_2,\sigma_2)}{p(I'_1(x)/\mu_{1-2},\sigma_{1-2})\,p(I'_2(x)/\mu_{1-2},\sigma_{1-2})} \quad (1),$$

et un premier seuil de confiance $T_1$ de valeur déterminée ;
$p(I'_i(x)/\mu_i,\sigma_i)$ étant la fonction de densité de probabilité pour le niveau de gris $I'_i(x)$ d'un pixel de l'image normalisée $I'_i$, calculée avec une fonction Gaussienne de moyenne $\mu_i$ et d'écart type $\sigma_i$ de présenter le niveau de gris observé, l'indice 1-2 s'appliquant aux valeurs combinées des images normalisées $I'_1$ et $I'_2$,
les statistiques pour un pixel donné étant réalisées sur une zone s'étendant autour du pixel sur un nombre déterminé de pixels.

5. Procédé de quantification de l'évolution de pathologies impliquant des changements de volume de corps selon l'une quelconque des revendications précédentes, **caractérisé en ce qu'**un deuxième test réalise la comparaison entre la fonction de densité de probabilité $p(I'_2(x) - I'_1(x)/\mu_2 - \mu_1,\sqrt{\sigma_1^2 + \sigma_2^2})$ et un deuxième seuil de confiance $T_2$ de valeur déterminée.

6. Procédé de quantification de l'évolution de pathologies impliquant des changements de volume de corps selon l'une quelconque des revendications précédentes, **caractérisé en ce qu'**un troisième test réalise la comparaison entre la valeur de probabilité

$F(|I'_2(x) - I'_1(x)|,0,\sqrt{\sigma_1^2 + \sigma_2^2})$ et un troisième seuil de confiance $T_3$ de valeur déterminée, la fonction $F$ désignant l'intégrale

$$F(t,\mu,\sigma) = 1 - \int_{-t}^{t} \frac{e^{\frac{-(s-\mu)^2}{2\sigma^2}}}{\sqrt{2\pi}\sigma} ds$$

7. Procédé de quantification de l'évolution de pathologies impliquant des changements de volume de corps selon la revendication 4, **caractérisé en ce que** la comparaison réalisée par le premier test réalisé à la troisième étape (103) est établie par la relation suivante :

$$\ln\left(\frac{p(I'_1(x)/\mu_1,\sigma_1)p(I'_2(x)/\mu_2,\sigma_2)}{p(I'_1(x)/\mu_{1-2},\sigma_{1-2})p(I'_2(x)/\mu_{1-2},\sigma_{1-2})}\right) > \ln(T_1) \quad (3).$$

8. Procédé de quantification de l'évolution de pathologies impliquant des changements de volume de corps selon la revendication 7, **caractérisé en ce que** le premier seuil de confiance $T_1$ est égal à 2.

9. Procédé de quantification de l'évolution de pathologies impliquant des changements de volume de corps selon-la revendication 5, **caractérisé en ce que** la comparaison réalisée par le deuxième test réalisé à la troisième étape (103) est établie par la relation suivante :

$$p(I'_2(x) - I'_1(x)/\mu_2 - \mu_1, \sqrt{\sigma_1^2 + \sigma_2^2}) < T_2 \quad (5),$$

10. Procédé de quantification de l'évolution de pathologies impliquant des changements de volume de corps selon la revendication 9, **caractérisé en ce que** le deuxième seuil de confiance $T_2$ est égal à $\dfrac{e^{-\alpha}}{\sqrt{2\pi\sigma_n^2}}$, $\alpha$ étant un nombre réel positif non nul paramétrable, et $\sigma_n$ représentant l'écart type du bruit dans la carte des différences.

11. Procédé de quantification de l'évolution de pathologies impliquant des changements de volume de corps selon la revendication 6, **caractérisé en ce que** la comparaison réalisée par le troisième test réalisé à la troisième étape (103) est établie par la relation suivante :

$$F(|I'_2(x) - I'_1(x)|, 0, \sqrt{\sigma_1^2 + \sigma_2^2}) < T_3,$$

le troisième seuil de confiance $T_3$ étant un nombre réel positif non nul très petit devant 1.

12. Procédé de quantification de l'évolution de pathologies impliquant des changements de volume de corps selon l'une quelconque des revendications précédentes, **caractérisé en ce que** les tests réalisés à la troisième étape (103) sont réalisés pour tous les pixels constituant les images normalisées $I'_1$ et $I'_2$ et/ou la carte des différences calculée à la deuxième étape (102).

13. Procédé de quantification de l'évolution de pathologies impliquant des changements de volume de corps selon l'une quelconque des revendications précédentes, **caractérisé en ce que** les tests réalisés à la troisième étape (103) sont réalisés sur la base de moyennes locales se fondant sur des pluralités de pixels des images normalisées $I'_1$ et $I'_2$ et/ou de la carte des différences calculée à la deuxième étape (102) formant une pluralité de zones couvrant les images normalisées $I'_1$ et $I'_2$ et/ou la carte des différences.

14. Procédé de quantification de l'évolution de pathologies impliquant des changements de volume de corps selon l'une quelconque des revendications précédentes, **caractérisé en ce que** le premier test et/ou le deuxième test et/ou le troisième test sont réalisés à la troisième étape (103), les résultats de ces tests étant combinés lors d'une quatrième étape (104).

**15.** Procédé de quantification de l'évolution de pathologies impliquant des changements de volume de corps selon l'une quelconque des revendications précédentes, **caractérisé en ce que** ladite pathologie est une tumeur cérébrale.

**16.** Dispositif de programme d'ordinateur, **caractérisé en ce qu'**il met en oeuvre un procédé de quantification de l'évolution de pathologies impliquant des changements de volume de corps selon l'une quelconque des revendications précédentes.

**Patentansprüche**

**1.** Verfahren zur Quantifizierung der Entwicklung von Pathologien, die Veränderungen im Volumen von Körpern einschließen, dargestellt über eine Bildgebungstechnik, **dadurch gekennzeichnet, dass** es mindestens Folgendes umfasst:

• einen ersten Schritt (101) des Normalisierens von Grauwerten durch eine Mischtechnik von zwei Bildern $I_1$ und $I_2$ die eine gleiche Szene darstellen, was zu zwei normalisierten Bildern $I_1$' und $I_2$' führt,
• einen zweiten Schritt (102) des Berechnens einer Differenzkarte, gezeichnet zwischen den zwei normalisierten Bildern $I_1$' und $I_2$',
• einen dritten Schritt (103), umfassend mindestens einen statistischen Test, der auf der Hypothese einer Gauß'schen Verteilung der Grauwerte der gesunden Gewebe der normalisierten Bilder $I_1$' und $I_2$' und/oder der Differenzkarte, berechnet im zweiten Schritt (102) basiert.

**2.** Verfahren zur Quantifizierung der Entwicklung von Pathologien, die Veränderungen im Volumen von Körpern einschließen, nach Anspruch 1, **dadurch gekennzeichnet, dass** der erste Schritt (101) des Normalisierens ein auf halbem Wege kumuliertes Histogramm der Grauwerte bestimmt, das den zwei Bildern $I_1$ und $I_2$ gemeinsam und gleich dem Kehrwert des arithmetischen Mittels der Kehrwerte der kumulierten Histogramme von Grauwerten der zwei nomalisierten Bilder $1_1$ und $1_2$ ist, wobei die zwei Bilder durch die Anwendung des auf halbem Wege kumulierten Histogramms an den zwei Bildern $I_1$ und $I_2$ normalisiert werden

**3.** Verfahren zur Quantifizierung der Entwicklung von Pathologien, die Veränderungen im Volumen von Körpern einschließen, nach Anspruch 1, **dadurch gekennzeichnet, dass** der erste Schritt (101) des Normalisierens ein auf halbem Wege kumuliertes Histogramm von Grauwerten bestimmt, das den zwei Bildern $I_1$ und $I_2$ gemeinsam und gleich dem Kehrwert des arithmetischen Mittels der Kehrwerte der kumulierten Histogramme von Grauwerten der zwei Bilder $I_1$ und $I_2$ ist, wobei die zwei Bilder auf dem gemischten kumulierten Histogramm an den zwei Bildern $I_1$ und $I_2$ normalisiert werden.

**4.** Verfahren zur Quantifizierung der Entwicklung von Pathologien, die Veränderungen im Volumen von Körpern einschließen, nach einem der vorhergehenden Ansprüche, **dadurch gekennzeichnet, dass** ein erster Test den Vergleich zwischen eines generalisierten Wahrscheinlichkeitsverhältnisses durchführt, definiert durch die folgende Relation:

$$GLRT = \frac{p(I'_1(x)/\mu_1, \sigma_1) p(I'_2(x)/\mu_2, \sigma_2)}{p(I'_1(x)/\mu_{1-2}, \sigma_{1-2}) p(I'_2(x)/\mu_{1-2}, \sigma_{1-2})} \quad (1),$$

und einer ersten Zuverlässigkeitsschwelle $T_1$ mit einem bestimmten Wert; wobei $p(I'_i(x)/\mu_i, \sigma_i)$ die Wahrscheinlichkeitsdichtefunktion für den Grauwert $I'_i(x)$ eines Pixels des normalisierten Bildes $I'_i$ ist, berechnet mit einer Gauß'schen Funktion mit dem Mittelwert $\mu_i$ und der Abweichung $\sigma_i$ zur Darstellung des beobachteten Grauwerts, wobei der Index 1 - 2 auf die kombinierten Werte der normalisierten Bilder $I'_1$ und $I'_2$ angewendet wird, wobei die Statistiken für ein bestimmtes Pixel auf einem Bereich durchgeführt werden, der sich um das Pixel über bestimmte Anzahl von Pixeln erstreckt.

**5.** Verfahren zur Quantifizierung der Entwicklung von Pathologien, die Veränderungen im Volumen von Körpern einschließen, nach einem der vorhergehenden Ansprüche, **dadurch gekennzeichnet, dass** ein zweiter Test den Vergleich zwischen der Wahrscheinlichkeitsdichtefunktion $p(I'_2(x) - I'_1(x) / \mu_2 - \mu_1, \sqrt{\sigma_1^2 + \sigma_2^2})$ und einer zweiten Zuverlässigkeitsschwelle $T_2$ mit einem bestimmten Wert durchführt;

6. Verfahren zur Quantifizierung der Entwicklung von Pathologien, die Veränderungen im Volumen von Körpern einschließen, nach einem der vorhergehenden Ansprüche, **dadurch gekennzeichnet, dass** ein dritter Test den Vergleich zwischen dem Wahrscheinlichkeitswert $F(|I'_2(x) - I'_1(x)|, 0, \sqrt{\sigma_1^2 + \sigma_2^2})$ und einer dritten Zuverlässigkeitsschwelle $T_3$ mit einem bestimmten Wert durchführt, wobei die Funktion $F$ das folgende Integral bezeichnet:

$$F(t, \mu, \sigma) = 1 - \int_{-t}^{t} \frac{e^{\frac{-(s-\mu)^2}{2\sigma^2}}}{\sqrt{2\pi}\sigma} ds$$

7. Verfahren zur Quantifizierung der Entwicklung von Pathologien, die Veränderungen im Volumen von Körpern einschließen, nach Anspruch 4, **dadurch gekennzeichnet, dass** der Vergleich, durchgeführt vom ersten Test, durchgeführt im dritten Schritt (1 03)durch die folgende Relation bestimmt wird:

$$\ln\left(\frac{p(I'_1(x) / \mu_1, \sigma_1)p(I'_2(x) / \mu_2, \sigma_2)}{p(I'_1(x) / \mu_{1-2}, \sigma_{1-2})p(I'_2(x) / \mu_{1-2}, \sigma_{1-2})}\right) > \ln(T_1) \quad (3).$$

8. Verfahren zur Quantifizierung der Entwicklung von Pathologien, die Veränderungen im Volumen von Körpern einschließen, nach Anspruch 7, **dadurch gekennzeichnet, dass** die erste Zuverlässigkeitsschwelle $T_1$ gleich 2 ist.

9. Verfahren zur Quantifizierung der Entwicklung von Pathologien, die Veränderungen im Volumen von Körpern einschließen, nach Anspruch 5, **dadurch gekennzeichnet, dass** der Vergleich, der vom zweiten Test, durchgeführt im dritten Schritt (103), durchgeführt wird, durch die folgende Relation bestimmt wird:

$$p(I'_2(x) - I'_1(x) / \mu_2 - \mu_1, \sqrt{\sigma_1^2 + \sigma_2^2}) < T_2 \quad (5),$$

10. Verfahren zur Quantifizierung der Entwicklung von Pathologien, die Veränderungen im Volumen von Körpern einschließen, nach Anspruch 9, **dadurch gekennzeichnet, dass** die zweite Zuverlässigkeitsschwelle $T_2$ gleich $\frac{e^{-\alpha}}{\sqrt{2\pi\sigma_n^2}}$, ist, wobei $\alpha$ eine parametrierbare positive reelle Zahl, verschieden von null, ist, und $\sigma_n$ die typische Abweichung des Rauschens in der Differenzkarte ist.

11. Verfahren zur Quantifizierung der Entwicklung von Pathologien, die Veränderungen im Volumen von Körpern einschließen, nach Anspruch 6, **dadurch gekennzeichnet, dass** der Vergleich, der vom dritten Test, durchgeführt im dritten Schritt (103), durchgeführt wird, von der folgenden Relation bestimmt wird:

$$F(|I'_2(x) - I'_1(x)|, 0, \sqrt{\sigma_1^2 + \sigma_2^2}) < T_3,$$

wobei die dritte Zuverlässigkeitsschwelle $T_3$ eine sehr kleine positive reelle Zahl, verschieden von null, unter 1 ist.

**12.** Verfahren zur Quantifizierung der Entwicklung von Pathologien, die Veränderungen im Volumen von Körpern einschließen, nach einem der vorhergehenden Ansprüche, **dadurch gekennzeichnet, dass** die im dritten Schritt (103) durchgeführten Tests (103) für alle Pixel durchgeführt werden, die die normalisierten Bilder $I_1$' und $I_2$' darstellen und/oder der Differenzkarte, berechnet im zweiten Schritt (102).

**13.** Verfahren zur Quantifizierung der Entwicklung von Pathologien, die Veränderungen im Volumen von Körpern einschließen, nach einem der vorhergehenden Ansprüche, **dadurch gekennzeichnet, dass** die im dritten Schritt (103) durchgeführten Tests auf der Grundlage von lokalen Mittelwerten durchgeführt werden, die sich auf Vielzahlen von Pixeln der normalisierten Bilder $I_1$' und $I_2$', und/oder der Differenzkarte, berechnet im zweiten Schritt (102), stützen, die eine Vielzahl von Bereichen bilden, die die normalisierten Bilder $I_1$' und $I_2$' und/oder die Differenzkarte abdecken.

**14.** Verfahren zur Quantifizierung der Entwicklung von Pathologien, die Veränderungen im Volumen von Körpern einschließen, nach einem der vorhergehenden Ansprüche, **dadurch gekennzeichnet, dass** der erste Test und/oder der zweite Test und/oder der dritte Test im dritten Schritt (103) durchgeführt werden, wobei die Ergebnisse dieser Tests in einem vierten Schritt (104) kombiniert werden.

**15.** Verfahren zur Quantifizierung der Entwicklung von Pathologien, die Veränderungen im Volumen von Körpern einschließen, nach einem der vorhergehenden Ansprüche, **dadurch gekennzeichnet, dass** die Pathologie ein Gehirntumor ist.

**16.** Computerprogrammvorrichtung, **dadurch gekennzeichnet, dass** es ein Verfahren zur Quantifizierung der Entwicklung von Pathologien, die Veränderungen im Volumen von Körpern einschließen, nach einem der vorhergehenden Ansprüche durchführt.

**Claims**

**1.** A method for quantifying the development of pathologies involving changes in volume of a body represented via an imaging technique, **characterized in that** it comprises at least:

- a first step (101) for normalization of gray levels by a midway technique for two images $I_1$ and $I_2$ representing the same scene, resulting in two normalized images $I_1$' and $I_2$',
- a second step (102) for calculation of a map of signed differences between the two normalized images $I_1$' and $I_2$',
- a third step (103) comprising at least one statistical test based on the assumption of a Gaussian distribution of the gray levels for the healthy tissues in the normalized images $I_1$' and $I_2$' and/or in the difference map calculated in the second step (102).

**2.** The method for quantifying the development of pathologies involving changes in volume of a body as claimed in claim 1, **characterized in that** the first normalization step (101) determines a midway cumulative histogram of gray levels common to the two images $I_1$ and $I_2$, and equal to the inverse of the arithmetic mean of the inverses of the cumulative histograms of gray levels for the two normalized images $I_1$ and $I_2$, the two images being normalized by application of the midway cumulative histogram to the two images $I_1$ and $I_2$.

**3.** The method for quantifying the development of pathologies involving changes in volume of a body as claimed in claim 1, **characterized in that** the first normalization step (101) determines a midway cumulative histogram of gray levels common to the two images $I_1$ and $I_2$, and equal to the inverse of the geometric mean of the inverses of the cumulative histograms of gray levels for the two images $I_1$ and $I_2$, the two images being normalized on the midway cumulative histogram to the two images $I_1$ and $I_2$.

**4.** The method for quantifying the development of pathologies involving changes in volume of a body as claimed in any one of the preceding claims, **characterized in that** a first test performs the comparison between a generalized likelihood ratio defined by the equation:

$$GLRT = \frac{p(I'_1(x)/\mu_1,\sigma_1)\,p(I'_2(x)/\mu_2,\sigma_2)}{p(I'_1(x)/\mu_{1-2},\sigma_{1-2})\,p(I'_2(x)/\mu_{1-2},\sigma_{1-2})} \quad (1),$$

and a first confidence threshold T$_1$ of given value;

$p(I'_i(x)/\mu_i,\sigma_i)$ being the probability density function for the gray level I'$_i$(x) of a pixel of the normalized image I'$_i$, calculated with a Gaussian function of mean $\mu_i$ and standard deviation $\sigma_i$ to exhibit the observed gray level, the index 1-2 being applicable to the combined values of the normalized images I'$_1$ and I'$_2$,

the statistics for a given pixel being determined over an area extending around the pixel over a given number of pixels.

5. The method for quantifying the development of pathologies involving changes in volume of a body as claimed in any one of the preceding claims, **characterized in that** a second test performs the comparison between the probability density function $p(I'_2(x) - I'_1(x)/\mu_2 - \mu_1, \sqrt{\sigma_1^2 + \sigma_2^2})$ and a second confidence threshold T$_2$ of given value.

6. The method for quantifying the development of pathologies involving changes in volume of a body as claimed in any one of the preceding claims, **characterized in that** a third test performs the comparison between the probability value $F(|I'_2(x) - I'_1(x)|, 0, \sqrt{\sigma_1^2 + \sigma_2^2})$ and a third confidence threshold T$_3$ of given value, the function F denoting the integral

$$F(t, \mu, \sigma) = 1 - \int_{-t}^{t} \frac{e^{\frac{-(s-\mu)^2}{2\sigma^2}}}{\sqrt{2\pi}\sigma} ds .$$

7. The method for quantifying the development of pathologies involving changes in volume of a body as claimed in claim 4, **characterized in that** the comparison performed by the first test carried out at the third step (103) is established by the following equation:

$$\ln(\frac{p(I'_1(x)/\mu_1,\sigma_1)p(I'_2(x)/\mu_2,\sigma_2)}{p(I'_1(x)/\mu_{1-2},\sigma_{1-2})p(I'_2(x)/\mu_{1-2},\sigma_{1-2})}) > \ln(T_1) \ (3).$$

8. The method for quantifying the development of pathologies involving changes in volume of a body as claimed in claim 7, **characterized in that** the first confidence threshold T$_1$ is equal to 2.

9. The method for quantifying the development of pathologies involving changes in volume of a body as claimed in claim 5, **characterized in that** the comparison performed by the second test carried out at the third step (103) is established by the following equation:

$$p(I'_2(x) - I'_1(x)/\mu_2 - \mu_1, \sqrt{\sigma_1^2 + \sigma_2^2}) < T_2 \ (5).$$

10. The method for quantifying the development of pathologies involving changes in volume of a body as claimed in claim 9, **characterized in that** the second confidence threshold T$_2$ is equal to $\dfrac{e^{-\alpha}}{\sqrt{2\pi\sigma_n^2}}$, $\alpha$ being a variable non-zero positive real number, and $\sigma_n$ representing the standard deviation of the noise in the difference map.

11. The method for quantifying the development of pathologies involving changes in volume of a body as claimed in claim 6, **characterized in that** the comparison performed by the third test carried out at the third step (103) is established by the following equation:

$$F\left(\left|I'_2(x) - I'_1(x)\right|, 0, \sqrt{\sigma_1^2 + \sigma_2^2}\right) < \mathsf{T}_3,$$

the third confidence threshold $T_3$ being a non-zero positive real number much less than 1.

**12.** The method for quantifying the development of pathologies involving changes in volume of a body as claimed in any one of the preceding claims, **characterized in that** the tests carried out at the third step (103) are carried out for all the pixels composing the normalized images $I'_1$ and $I'_2$ and/or the difference map calculated at the second step (102).

**13.** The method for quantifying the development of pathologies involving changes in volume of a body as claimed in any one of the preceding claims, **characterized in that** the tests carried out at the third step (103) are carried out on the basis of local means based on pluralities of pixels from the normalized images $I'_1$ and $I'_2$ and/or from the difference map calculated at the second step (102) forming a plurality of areas covering the normalized images $I'_1$ and $I'_2$ and/or the difference map.

**14.** The method for quantifying the development of pathologies involving changes in volume of a body as claimed in any one of the preceding claims, **characterized in that** the first test and/or the second test and/or the third test are carried out at the third step (103), the results of these tests being combined during a fourth step (104).

**15.** The method for quantifying the development of pathologies involving changes in volume of a body as claimed in any one of the preceding claims, **characterized in that** said pathology is a brain tumor.

**16.** A computer program device, **characterized in that** it implements a method for quantifying the development of pathologies involving changes in volume of a body as claimed in any one of the preceding claims.

FIG.1

$H_1$

$H_2$

$I_1$

$I_2$

$\varphi_1(I_1)$

$\varphi_2(I_2)$

$\varphi_1^{-1} \circ \varphi_2 = H_1^{-1} \circ H_2$

$I'_1$

$I'_2$

$H_1 \circ \varphi_1^{-1}$

$H_2 \circ \varphi_2^{-1}$

$H_{midway}$

$H_{midway}$

FIG.2

FLAIR t₁ FLAIR t₂

Différence Différence mi-chemin Différence ½ max

SPGR t₁ SPGR t₂

Différence Différence mi-chemin Différence ½ max

FIG.3

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **VAIDYANATHAM et al.** Comparison of supervised MRI segmentation methods for tumor volume determination during therapy. *Magnetic Resonance Imaging UK,* 1995, vol. 13 (5), 719-728

- **J. DELON.** Midway Image Equalization. *Journal of Mathematical Imaging and Vision,* 2004, vol. 21 (2), 119-134